# EUROPEAN PATENT APPLICATION

(11) **EP 1 522 530 A1**
(43) Date of publication of application: **13.04.2005**
(21) Application number: 03756109.9
(22) Date of filing: 22.05.2003
(51) Int. Cl.: C03B 29/04

(54) **METHOD FOR PREPARING DIAMOND FROM GRAPHITE BY INNER SHELL ELECTRON EXCITATION**

(30) Priority: 30.05.2002 JP 2002156937
(71) Applicant: Japan Science and Technology Agency, Kawaguchi-shi, Saitama 332-0012 (JP)
(72) Inventor: YOSHIDA, Hiroshi, Kawanishi-shi, Hyogo 666-0111 (JP); NAKAYAMA, Hiroyuki, Ibogawa-cho, Ibo-gun, Hyogo 671-1643 (JP)
(74) Representative: Röthinger, Rainer, Dipl.-Phys.
(86) International application number: PCT/JP2003/006426
(87) International publication number: WO 2003/101899

(57) **Abstract**

If a stable graphite structure is reversed to a stable diamond structure using some excited state established at normal temperature and pressure, graphite can easily be transformed into diamond. If this technique is realized, it is expected to be applied to nanotechnology, short-wavelength, high-power semiconductor lasers, and high-power electronics.

A method for producing diamond includes the step of exposing single-crystal or polycrystalline graphite having an sp² structure to one selected from the group consisting of synchrotron radiation X-rays, radiation, laser light, an electron beam, and accelerated multicharged ions under normal pressure to excite the 1s inner-shell electrons of carbon atoms (C) constituting the graphite, thereby producing diamond having an sp³ structure from the graphite having the sp² structure. The method inexpensively produces single-crystal diamond, polycrystalline diamond, or nanostructural diamond in a large amount.

## Description

### Technical Field

The present invention relates to a method for producing single-crystal diamond, polycrystalline diamond, and nanostructural diamond constituted of nanoscale particles, by inner-shell electron excitation using graphite as a starting material.

### Background Art

For synthesizing diamond, in general, graphite may be transformed into a diamond structure in the presence of a nickel catalyst under high pressure, or hydrogenated carbon gas may be photolyzed to be deposited. These methods, however, produce only polycrystalline or microcrystalline diamond. The known methods involve significant disadvantages that the resulting crystals have poor quality and contain a large amount of impurities, and thus do not lead to the production of low-resistance n-type single crystals. Therefore, there is no application to the field of semiconductor devices.

Also, in the existing diamond production, not only single-crystal diamond but also nanostructural diamond constituted of nanoscale particles and doped nanostructural diamond used as functional semiconductor are not produced in controlled size with high precision.

Graphite is more thermodynamically stable than diamond, in a thermal equilibrium state under conditions of normal temperature and pressure. Diamond is used in a variety of applications, such as high-temperature, high-power semiconductor devices, UV lasers, and functional semiconductors including semiconductor spin electronics. In general, diamond is synthesized from a starting material graphite in the presence of a catalyst under conditions of high temperature and pressure because it is metastable at normal temperature and pressure.

The inventors of the present invention have devised an alternative to the above-described known methods, for synthesizing single crystal diamond with hydrogenated amorphous carbon (Patent Document 1). Patent Documents 2 and 3 have disclosed methods for producing diamond thin films and the like by exposing a carbon material containing -C≡C-C and/or =c= to at least one selected from among light, an electron beam, and an ion beam.

In addition, if a stable graphite structure is reversed to a stable diamond structure using some excited state established at normal temperature and pressure, graphite can easily be transformed into diamond. If this technique is realized, it is expected to be applied to nanotechnology, short-wavelength, high-power semiconductor lasers, and high-power electronics.
Patent Document 1: Japanese Unexamined Patent Application Publication No. 9-20593 (Japanese Patent No. 3232470)
Patent Document 2: Japanese Unexamined Patent Application Publication No. 11-310408
Patent Document 3: Japanese Unexamined Patent Application Publication No. 2000-16806

### Disclosure of Invention

In order to achieve the above-described challenge, the inventors of the present invention have developed a novel method for producing diamond by non-equilibrium inner-shell excitation. The method produces single-crystal diamond, polycrystalline diamond, and nanostructural diamond from graphite by 1s inner-shell electron excitation of carbon atoms (C).

Since the known method of diamond synthesis is performed under high pressure, contamination from air or the catalyst often occurs, and the product is a low crystalline aggregate of polycrystal or microcrystal. However, the method of the present invention can structurally transform a graphite thin film into a single-crystal diamond thin film, maintaining the original form, and also structurally transform graphite deposited on a semiconductor substrate into diamond, maintaining the original form.

In the present invention, single crystal or polycrystalline graphite is exposed to high-energy light, electrons, or ions such as synchrotron radiation X-rays, laser light, radiation, an electron beam, or accelerated multicharged ions to excite inner-shell 1s electrons of the carbon atoms (c) constituting the graphite, and thus to introduce inner-shell 1s holes, thereby making the excited carbon atoms stable in a diamond structure rather than in a graphite structure. Thus, a large amount of diamond can be inexpensively produced from graphite.

Specifically, the present invention is directed to a method in which an sp³ diamond structure is produced from the sp² structure of graphite by exposing single-crystal or polycrystalline graphite to any one of synchrotron radiation X-rays, radiation, laser light, an electron beam, and accelerated multicharged ions to excite the 1s inner-shell electrons of sp²-bonded carbon atoms (C) constituting the graphite under normal pressure.

In the method, exposure time may be controlled so as to produce single-crystal diamond, polycrystalline diamond, or nanostructural diamond constituted of nanoscale particles according to the controlled exposure time.

In the method, exposure time, exposure intensity, or temperature of a substrate on which the graphite lies may be controlled so as to produce microcrystalline diamond or nanostructural diamond according to the controlled conditions.

In the method, the graphite used as a starting material may contain at least one type of dopant atoms selected from the group consisting of transition metal dopant, rare-earth metal dopant, donor dopant, and acceptor dopant and thus the diamond contains the dopant atoms.

In the method, the graphite having the sp² structure may be provided with a gate, a source, and a drain with a metal to prepare a field-effect transistor (FET), and a negative gate voltage is applied to the FET to dope the crystal of the graphite with a hole, whereby the diamond having the sp³ structure becomes more stable than the graphite having the sp² structure.

In the method, the graphite may be doped with an acceptor, such as B atoms, Al atoms, Ga atoms, or In atoms, to allow the diamond of sp³ structure to be more stable than the graphite of sp² structure.

### (Operation)

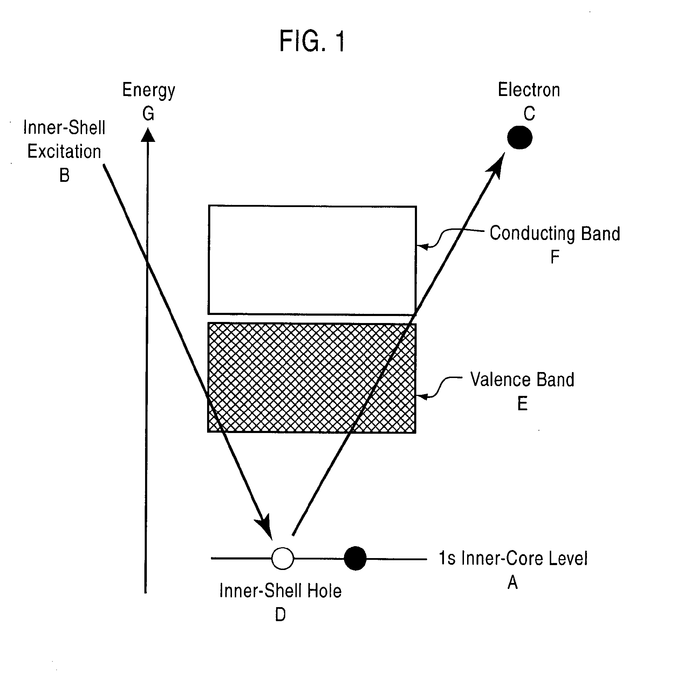

Fig. 1 is a schematic diagram showing the excitation of an inner-shell 1s electron of a carbon atom constituting graphite. In the method of the present invention, the reaction of structurally changing graphite into diamond occurs in a solid phase.

When an electron in the 1s core level (A) of an carbon atom constituting graphite having an sp² structure is excited by high-energy light, electrons, or ions such as synchrotron radiation X-rays, laser light, radiation, an electron beam, or accelerated multicharged ions, an inner-shell 1s electron (C) of the carbon atom is emitted from the graphite to a vacuum through the surface of the graphite, and thus a inner-shell excitation state having an inner-shell hole (D) is formed for 1 to 20 fs. Although the inner-shell hole is blocked with electrons in a valence band (E) and conducting band (F), it has a lifetime of 1 to 20 fs. The energy (G) level in Fig. 1 increases upward, as designated by the arrow.

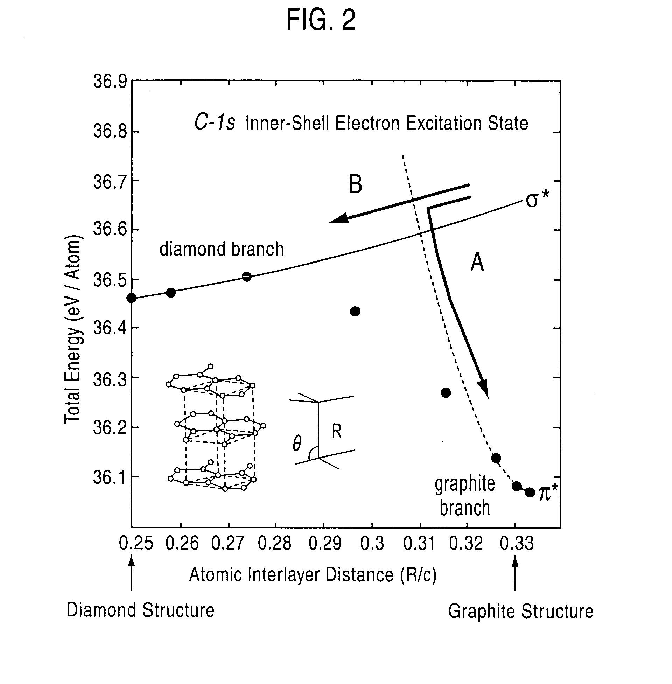

Fig. 2 is a graph showing, as functions of interatomic distance, the total energies of a diamond structure and a graphite structure (R: graphite interlayer distance, θ: graphite interatomic angle) in which inner-shell 1s electrons are excited to have a hole in each 1s inner-shell orbital.

Even in such an excited state, the graphite structure is more energetically stable than the diamond structure. As designated by the dotted line along arrow A in Fig. 2, the energy state of the graphite structure is almost restored from the inner shell excited state to an initial state. However, since the transformation from the stable graphite structure to a metastable diamond structure involves an excited state, there is some limited probability of transforming in the direction of the solid line designated by arrow B though the probability is much lower than that in the ground state.

Unfortunately, the lifetime of the excited inner-shell 1s electron is as short as 1 to 20 fs, and accordingly carbon atoms can move only a short distance in such a short period. Hence, the probability that the stable graphite transforms into metastable diamond is low.

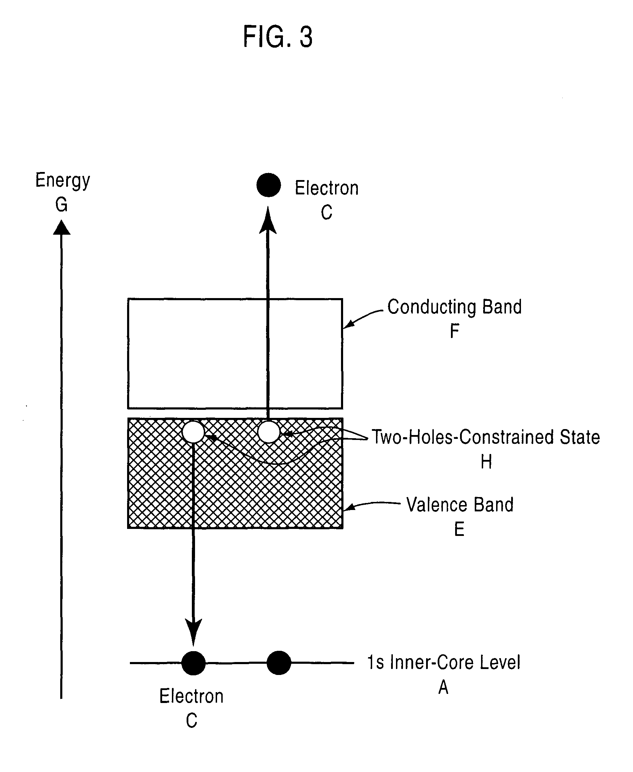

Fig. 3 is a schematic diagram of a two-holes-constrained state (H) in which two holes are constrained in a valence band (E), and which is formed by transfer from the excited state of the inner-shell 1s electron of the carbon constituting graphite and by subsequent Auger effect (decay).

As shown in Fig. 3, in 1 to 20 fs after an electron of a carbon in the 1s core level (A) is excited, Auger effect (decay) occurs and a 2p valence electron falls from the valence band (E) to the 1s inner-shell hole due to dipole transition. At the same time, in order to conserve the energy in the atomic position, a valence electron (C) having the same energy but a reverse momentum is emitted into a vacuum according to the low of conservation of energy and the low of conservation of momentum. Thus, two holes are formed in the valence band (E). Consequently, a two-holes-constrained state (H) is formed in which the two holes are localized in the valence band (E).

Thus, the carbons in the graphite structure can be transformed to a final ionic state, C²⁺. Since the lifetime of the final ionic state C²⁺ is as long as one picosecond to several tens of picoseconds, light C atoms can sufficiently widely move due to lattice vibration in such a long time.

In the C²⁺ final state (two-holes-constrained excitation state), the π band constituted of a pz orbital in the valence band lacks an electron. By filling this band with electrons, the sp² structure of graphite is stabilized, and thus graphite in a layered structure is stabilized. Therefore, the two-holes-constrained state, in which the band lacks in two electrons for its final state due to inner-shell excitation and Auger effect, allows diamond having an sp³ structure to be more stable than graphite having an sp² structure.

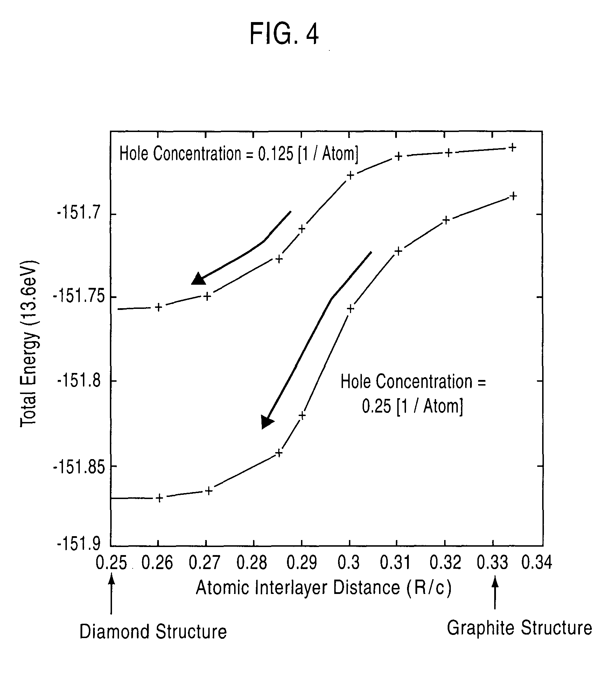

Fig. 4 is a graph showing, as functions of interatomic distance, the total energies of a graphite structure and a diamond structure being the final state for the two-holes-constrained sate resulting from Auger effect. The structures are transformed along the functional curves, and the graphite structure becomes unstable in such excited state, thus transforming into a diamond structure spontaneously.

In the final state (excited state) having two constrained holes, or C²⁺, the total energy of diamond having an sp³ structure is lower than that of graphite having a sp² structure, in contrast to the ground state. Therefore, a graphite structure can be spontaneously transformed into diamond by lattice vibration in an excited state.

By using the reversed phenomena of the stable structure in the excited state, which is completely different from the ground state, the crystalline structure of graphite can be gradually transformed into that of diamond, and thus the diamond structure can be stabilized.

The diamond structure depends on exposure time (excitation length) of, for example, synchrotron radiation X-ray. Specifically, single-crystal diamond is obtained by setting the exposure time on the order of minutes, or in the range of about 1 to 5 minutes; nanostructural diamond, on the order of seconds, or in the range of about 1 to 5 seconds; polycrystalline diamond, between these periods of time.

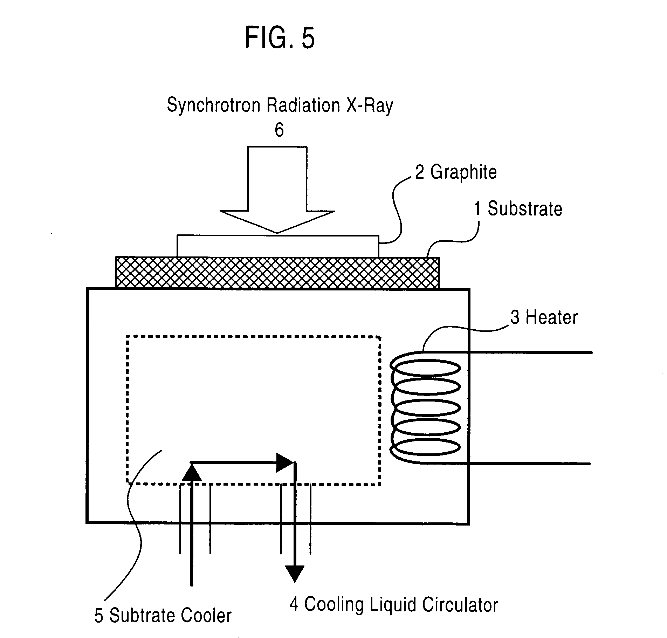

Fig. 5 is a schematic illustration of an apparatus for carrying out the method of the present invention. As shown in Fig. 5, single-crystal or polycrystalline graphite 2 is put on a diamond or sapphire substrate 1. The temperature of the substrate is controlled with a heater 3, or a cooling liquid circulator 4 and a substrate cooler 5 to maintain the graphite at a predetermined temperature. The atmosphere is not necessarily a vacuum, but normal atmosphere oxidizes diamond to consume it. Therefore, the method is generally performed in a vacuum or a rare gas atmosphere.

Then, any one of synchrotron radiation X-rays, radiation, laser light, an electron beam, and accelerated multicharged ions is emitted onto the surface of the graphite 2 to excite the 1s inner-shell electrons of the layered carbon atoms (C) in the graphite. For example, synchrotron radiation X-rays 6 having an energy between 500 eV and 2,000 eV is emitted onto the surface of the graphite 2 under normal pressure. The energy of the emitted light must be at least 1s core level. By emitting intense soft X-rays from the synchrotron radiation, the region of the graphite exposed to the synchrotron radiation X-rays is entirely transformed into a diamond structure at normal temperature and pressure.

By setting the substrate temperature, which is a parameter for controlling the strength of atomic diffusion, in the range of 600 to 900°C, perfect single crystal can be produced. By setting the temperature of the substrate on which the graphite lies at a temperature of at least 900°C, and by emitting X-rays from the synchrotron radiation for 1 to 5 minutes, the single-crystal graphite can be substantially completely transformed into single-crystal diamond by 1s inner-shell electron excitation. If the temperature of the substrate on which the graphite lies is reduced to a level lower than a temperature of liquid nitrogen at which atoms are not diffused by heat, but by electron excitation, the graphite turns into a polycrystal.

By varying the intensity of the exposure, such synchrotron radiation X-rays, exposure time, and the temperature of the substrate on which the graphite lies, microcrystalline diamond having a small size or nanostructural diamond having a size between several tens of nanometers and several hundred nanometers can also be produced.

An acceptor (B, Al, or In) or a donor (P or N) may be added to the starting material single-crystal graphite as a dopant, or a transition metal, such as Cr or Mn, or a rare earth metal, such as Gd may be deposited on the graphite as a dopant to be compounded. Thus, by adding such a dopant to the nanostructural diamond and by exciting the inner-shell electron, p-type or n-type diamond or functional nanostructural diamond having ferromagnetism or a spin glass state can be produced.

Graphite having an sp² structure may be provided with a gate, a source, and a drain with a metal to prepare a field-effect transistor (FET), and a negative gate voltage is applied to the FET to dope the crystal with a hole. Thus, the sp³ structural diamond becomes more stable than the sp² structural graphite, and accordingly a sable diamond structure results.

Also, by heavily doping the carbon atoms (C) of sp² structural graphite with an acceptor, such as B atoms, Al atoms, Ga atoms, or In atoms, sp³ structural diamond can become more stable than the sp² structure graphite.

By setting the temperature of the substrate on which a single-crystal graphite lies at a liquid nitrogen temperature or less, nanostructural diamond including a dopant deposited on the graphite can be produced by inner-shell electron excitation. The size can be varied from 1.5 nanometers to 6 nanometers. Small crystals exhibit luminescence 10 to 120 times as strong as that of a bulk crystal due to a nanoscale exciton confinement effect. These products promise to be used in nanostructure lasers.

For exposure to UV laser light, inner-shell electrons are excited by multiphoton excitation because UV laser light is generally has a low energy. Also, strong laser light excites valence electrons to form a state doped with holes, thereby producing diamond from graphite.

### Brief Description of the Drawings

Fig. 1 is a schematic diagram showing the excitation of an inner-shell 1s electron of a carbon atom (C) constituting graphite. Fig. 2 is a graph of comparison in total energy as functions of carbon interatomic distance (R: interatomic distance; c: lattice constant) between diamond structure and graphite structure in carbon (C) inner-shell 1s electron excitation. Fig. 3 is a schematic diagram of a final state in which two holes are constrained in a valence band, and which is formed by Auger effect (decay) from the excited state of the inner-shell 1s electron of a carbon atom (C) constituting graphite. Fig. 4 is a graph of comparison in total energy as functions of carbon interatomic distance (R: interatomic distance; c: lattice constant) between diamond structure and graphite structure in a final state where two holes are constrained in a valence band, formed by carbon (C) inner-shell 1s electron excitation and subsequent Auger effect (decay). Fig. 5 is a schematic illustration of an apparatus for carrying out the method of the present invention. Fig. 6(a) is a graph of the coordination distribution by X-ray diffraction analysis of graphite before exposure to synchrotron radiation X-rays (three sp² coordinations represent 100% of the distribution); Fig. 6(b) is a graph of the coordination distribution by X-ray diffraction analysis of graphite after exposure to synchrotron radiation X-rays (four sp³ coordinations represent 100% of the distribution). Fig. 7 shows graphs for comparison in intensity of Raman scattering spectrometry between (a) graphite of sp² three-coordination structure at 2800 cm⁻¹ before exposure to synchrotron radiation X-rays and (b) diamond of sp³ four-coordination structure at 3300 cm⁻¹ after exposure to synchrotron radiation X-ray.

Best Mode for Carrying Out the Invention

### (EXAMPLES)

### EXAMPLE 1

### Example of single-crystal diamond production

As shown in Fig. 5, layered single-crystal graphite lying on a sapphire substrate, maintained at 300°C was exposed to synchrotron radiation X-rays having an energy of 500 to 2,000 eV for one minute under normal pressure to excite the carbon (C) 1s inner-shell electron.

The excitation of the inner shell electron from the 1s core level to a vacuum was confirmed by inner-shell electron spectrometry. A final state in which two holes were constrained in the carbon 2p orbital was observed by Auger spectrometry. As a result, it was confirmed by X-ray diffraction analysis and Raman scattering spectrometry that the layered single-crystal graphite which had been put on the substrate was transformed into single-crystal diamond.

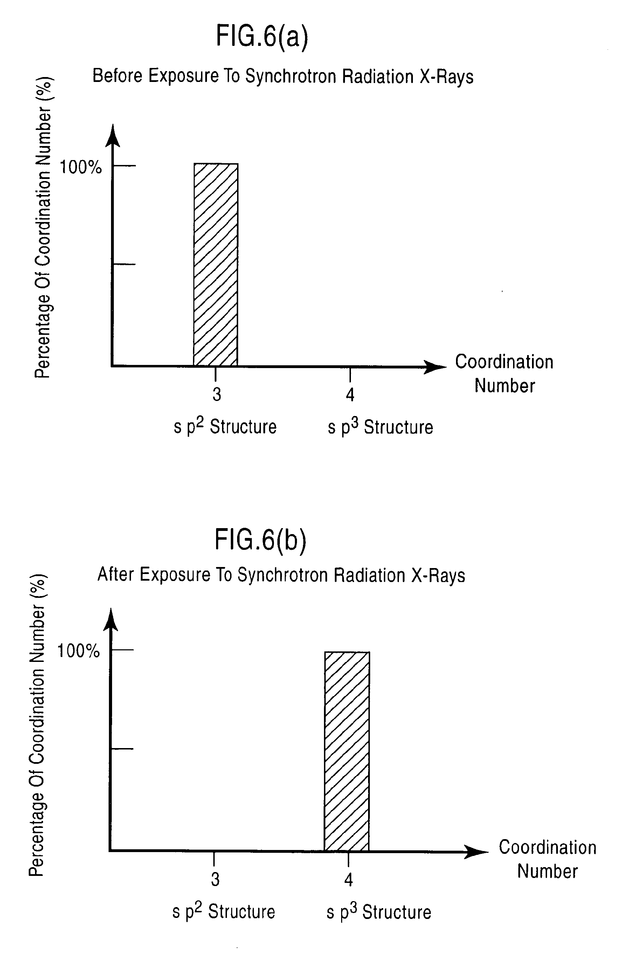

The coordination distribution of the graphite before exposure to synchrotron radiation X-rays was analyzed by X-ray diffraction. As a result, it has been found that three sp² coordinations represent substantially 100% (Fig. 6a).

Also, the coordination distribution of the resulting diamond after exposure to synchrotron radiation X-rays was analyzed. As a result, it has been found that four sp³ coordinations represent substantially 100%. Thus, the graphite was substantially completely transformed into diamond (Fig. 6b).

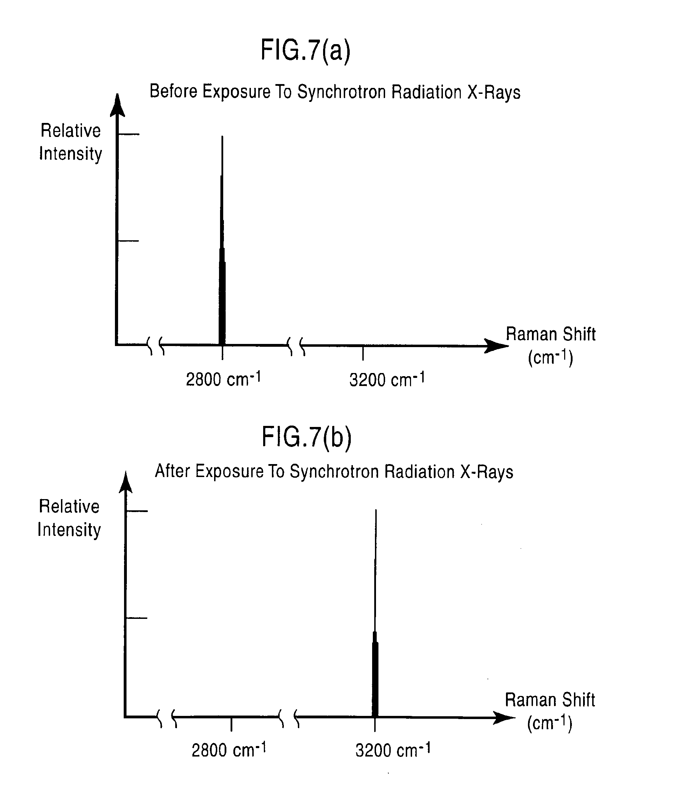

Furthermore, the Raman scattering spectrum intensity (Fig. 7a) at 2800 cm⁻¹ was examined for the sp² three-coordination structure of graphite before exposure to synchrotron radiation X-rays. The peak was completely shifted to a peak at 3300 cm⁻¹ of sp³ four-coordination structure (Fig. 7b). It has therefore been found that the graphite was substantially completely transformed into diamond by inner-shell excitation.

### EXAMPLE 2

### Example of nanostructural diamond production

As shown in Fig. 5, layered single-crystal graphite lying on a sapphire substrate was exposed to synchrotron radiation X-rays having an energy of 500 to 2,000 eV for five minutes at room temperature under normal pressure to excite the carbon (C) 1s inner-shell electron.

The excitation of the inner shell electron from the 1s core level to a vacuum was confirmed by inner-shell electron spectrometry. A final state in which two holes were constrained in the carbon 2p orbital was observed by Auger spectrometry.

As a result, it was confirmed by X-ray diffraction analysis and Raman scattering that the layered single crystal graphite was transformed into nanostructural diamond crystals by appropriately setting the intensity of the synchrotron radiation X-rays and the temperature of the substrate on which the graphite was put.

### EXAMPLE 3

By doping graphite being the starting material in advance with a transition metal dopant or rare-earth metal dopant, B atoms as acceptor, and Be atoms as donor, diamond can be produced at a lower pressure than in the case where graphite is singly used, and the resulting diamond has ferromagnetism or a spin glass state. Holes acting as carriers are doped with the implanted acceptor, and thereby ferromagnetic exchange interaction acts on the rare-earth metal or transition metal to establish ferromagnetism. While a system doped with Cr or Mn turns into an antiferromagnetic spin glass state, a system doped with Fe turns into ferromagnetic. In production of diamond from undoped graphite under high pressure, transition from graphite to diamond was not observed until temperature and pressure come to high values (1500°C, 50 GPa). In contrast, a starting material graphite doped with 6% to 10% of a transition metal or rare-earth metal and the above-described acceptor selected from among B atoms, Al atoms, Ga atoms, and In atoms, was transformed into diamond at a low temperature (800°C) and a low pressure (15 GPa). Conditions (temperature, pressure) under which graphite was transformed into diamond was as follows:
(1) Graphite alone: high temperature (1500°C) and high pressure (52 GPa)
(2) Graphite + acceptor Be atoms (6%), Mn atoms (6%): high temperature (1300°C) and high pressure (45 GPa): spin glass state
(3) Graphite + acceptor Al atoms (8%), Fe atoms (8%): high temperature (1100°C) and high pressure (28 GPa): ferromagnetic state
(4) Graphite + acceptor Ga atoms (9%), Mn atoms (6%): high temperature (1100°C) and high pressure (25 GPa): ferromagnetic state
(5) Graphite + acceptor In atoms (10%), Mn atoms (6%): high temperature (900°C) and high pressure (15 GPa): ferromagnetic state

### EXAMPLE 4

A SiO₂ insulating film is deposited on the surfaces of the carbon atoms constituting graphite, and aluminium is also deposited on the SiO₂ film to form a gate. Then, a negative voltage is applied to the gate to deposit a large amount of microcrystalline diamond on the surface of the graphite. This suggests that the graphite is doped with a large amount of holes by the application of gate voltage, particularly application of negative voltage, so that the energy of diamond structure becomes lower than that of graphite structure and, thus, the diamond structure is more stabilized spontaneously. Also, it has been found that in production of diamond by applying high pressure, graphite can be transformed into diamond at lower temperature and pressure by applying a gate voltage. The relationships between gate voltage and transition pressure of graphite to diamond (temperature was maintained at 800°C) were as follows:
(1) Gate voltage (150 V): transition pressure (20 GPa)
(2) Gate voltage (120 V): transition pressure (28 GPa)
(3) Gate voltage (800 V): transition pressure (32 GPa)
(4) Gate voltage (56 V): transition pressure (45 GPa)
(5) Gate voltage (20 V): transition pressure (50 GPa)

### EXAMPLE 5

By doping a starting material graphite in advance with trivalent B atoms, Al atoms, Ga atoms, or In atoms, which have lower electronic number than carbon atoms constituting the graphite, diamond can be produced from the graphite at lower pressure than in the case where graphite is singly used. In production of diamond from graphite under high pressure, transition from graphite to diamond was not observed until temperature and pressure come to high values (1500°C, 50 GPa). In contrast, a starting material graphite doped with 6% to 10% of the above-described acceptor selected from among B atoms, Al atoms, Ga atoms, and In atoms was transformed into diamond at a low temperature (900°C) and a low pressure (15 GPa). Conditions (temperature, pressure) under which graphite was transformed into diamond was as follows:
(1) Graphite alone: high temperature (1500°C) and high pressure (52 GPa)
(2) Graphite + acceptor B atoms (6%): high temperature (1400°C) and high pressure (45 GPa)
(3) Graphite + acceptor Al atoms (8%): high temperature (1200°C) and high pressure (30 GPa)
(4) Graphite + acceptor Ga atoms (9%): high temperature (1100°C) and high pressure (25 GPa)
(5) Graphite + acceptor In atoms (10%): high temperature (900°C) and high pressure (15 GPa)

### Industrial Applicability

Since diamond singe-crystal thin film is formed on a semiconductor by inner-shell 1s electron excitation under normal pressure using a graphite thin film formed on the semiconductor substrate as a starting material. Since the resulting diamond thin film has no dislocation or defect, it can be used as semiconductor material in devices.

Diamond has a wide band gap, and is accordingly useful as light-emitting sources of semiconductor UV lasers and semiconductor UV light. The present invention provides a material of future optoelectronics for high-density information. In addition, since diamond devices operate at high temperatures, it can be applied to high-temperature semiconductor devices.

For industrial application of diamond single-crystal thin films, low-resistance p-type and n-type crystals can be formed by doping with an acceptor and a donor, and they can be used in semiconductor devices for high-temperature, high power electronics and UV semiconductor laser diodes necessary for high-density recording and heavy information communication.

Also, since a transparent single-crystal protective film utilizing high hardness of diamond is inexpensively and easily produced in large amount, it is expected to be used in the field of packaging, protective films, machine tools, and so forth.

The present invention produces nanostructural diamond; p-type, n-type, and nanostructural diamond doped with a dopant; and nanostructural diamond doped with a transition metal or rare-earth metal, from single-crystal or polycrystalline graphite by inner-shell electron excitation. These types of diamond can be industrially used as materials for high-power optical devices and semiconductor spin electronics.

Furthermore, the nanostructural diamond exhibits nanoscale exciton confinement, and the confinement effect leads to strong light emission and increase spin-orbit interaction to produce a large magnetooptic effect. The nanostructural diamond can also be industrially used in high-power diamond lasers using an exciton luminescence mechanism and CW lasers using inner-shell transition of transition metal atoms or rare-earth metal atoms, emitting less temperature-dependant, sharp light.

## Claims

1. A method for producing diamond, comprising the step of: exposing single-crystal or polycrystalline graphite having an sp² structure to one selected from the group consisting of synchrotron radiation X-rays, radiation, laser light, an electron beam, and accelerated multicharged ions under normal pressure to excite the 1s inner-shell electrons of carbon atoms (C) constituting the graphite, thereby producing diamond having an sp³ structure from the graphite having the sp² structure.

2. The method for producing diamond according to Claim 1, wherein exposure time is controlled so as to produce single-crystal diamond, polycrystalline diamond, or nanostructural diamond constituted of nanoscale particles according to the controlled exposure time.

3. The method for producing diamond according to Claim 1, wherein exposure time, exposure intensity, or temperature of a substrate on which the graphite lies is controlled so as to produce microcrystalline diamond or nanostructural diamond according to the controlled conditions.

4. The method for producing diamond according to any one of Claims 1 to 3, wherein the graphite used as a starting material contains at least one type of dopant atoms selected from the group consisting of transition metal dopant, rare-earth metal dopant, donor dopant, and acceptor dopant and thus the diamond contains the dopant atoms.

5. The method for producing diamond according to any one of Claims 1 to 4, wherein the graphite having the sp² structure is provided with a gate, a source, and a drain with a metal to prepare a field-effect transistor (FET), and a negative gate voltage is applied to the FET to dope the crystal of the graphite with a hole, whereby the diamond having the sp³ structure becomes more stable than the graphite having the sp² structure.

6. The method for procuring diamond according to any one of Claims 1 to 4, wherein the graphite is doped with an acceptor, such as B atoms, Al atoms, Ga atoms, or In atoms, to allow the diamond having the sp³ structure to be more stable than the graphite having the sp² structure.
